# FASCICULE DE BREVET EUROPEEN

(11) **EP 0 486 359 B1**
(45) Date de publication et mention de la délivrance du brevet: **01.04.1998**
(21) Numéro de dépôt: 91402982.2
(22) Date de dépôt: 07.11.1991
(51) Int. Cl.: H03K 17/691, H03K 17/56, H03K 17/567

(54) **Circuit de commande de commutation basse fréquence de transistors à effet de champ et de transistors bipolaires à grille isolée**
NF-Schaltsteuerschaltung für Feldeffekttransistoren und Bipolartransistoren mit isoliertem Gate
Low frequency switching control circuit for field-effect transistors and insulated gate bipolar transistors

(30) Priorité: 16.11.1990 FR 9014323
(43) Date de publication de la demande: 20.05.1992
(73) Titulaire: GENERAL ELECTRIC CGR S.A., F-92130 Issy les Moulineaux (FR)
(72) Inventeur: Laeuffer, Jacques, F-75116 Paris (FR)
(74) Mandataire: Ballot, Paul Denis Jacques

(56) Documents cités:
- CH-A- 653 828
- GB-A- 2 109 184
- TECHNISCHE RUNDSCHAU, vol. 80, no. 34, 19 août 1988, pages 66-70; J. PALAND et al.: "Neue abschaltbare Leistungshalbleiter"
- PATENT ABSTRACTS OF JAPAN, vol. 13, no. 354 (E-802)[3702], 8 août 1989; & JP-A- 1 114 115 (YASKAWA ELECTRIC MFG CO., LTD) 02-05- 1989

## Description

La présente invention concerne les circuits pour commander les transistors à effet de champ réalisés en technologie du type à semiconducteurs Métal-Oxyde, plus connus sous l'abréviation anglaise MOSFET, ainsi que les transistors bipolaires à commande du type à Semiconducteurs Métal-Oxyde tels que les transistors bipolaires à grille isolée plus connus sous l'abréviation anglo-saxonne IGBT pour "Insulated Gate Bipolar Transistor".

Elle concerne plus particulièrement de tels transistors qui sont utilisés dans les circuits onduleurs à fréquence variable prévus pour alimenter les moteurs triphasés à l'aide de signaux basse fréquence et obtenir une vitesse variable desdits moteurs.

De tels moteurs triphasés à vitesse variable sont par exemple utilisés dans le domaine de la radiologie médicale où il est nécessaire de commander la vitesse de rotation de l'anode d'un tube émetteur de rayons X.

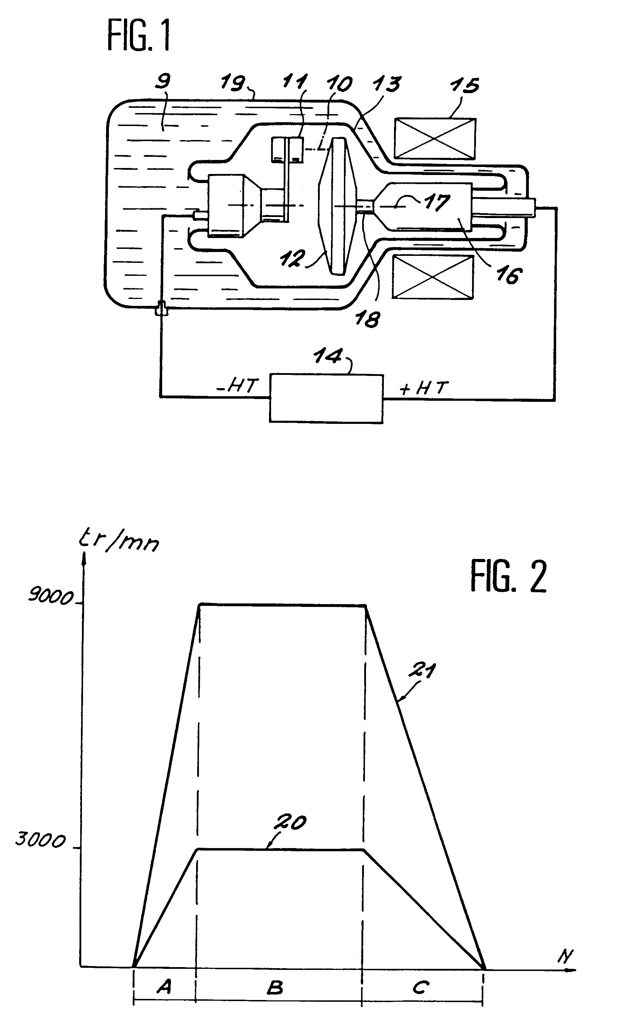

L'invention sera donc décrite dans son application au domaine de la radiologie médicale où il est nécessaire de commander la vitesse de rotation de l'anode d'un tube émetteur de rayons X. Comme le montre schématiquement la figure 1, un tel tube est généralement constitué comme une diode, c'est-à-dire avec une cathode 11 et une anode 12 ou anti-cathode, ces deux électrodes 11 et 12 étant enfermées dans une enveloppe 13 étanche au vide qui permet de réaliser l'isolement électrique entre ces deux électrodes. La cathode 11 produit un faisceau d'électrons 10 et l'anode 12 reçoit des électrons sur une petite surface qui constitue un foyer d'où sont émis les rayons X.

Quand la haute tension d'alimentation est appliquée aux bornes de la cathode 11 et de l'anode 12, de façon que la cathode soit au potentiel négatif, un courant dit courant anodique s'établit dans le circuit, au travers d'un générateur 14 produisant la haute tension d'alimentation; le courant anodique traverse l'espace entre la cathode et l'anode sous la forme du faisceau d'électrons qui bombardent le foyer.

Une faible proportion (1%) de l'énergie dépensée à produire le faisceau d'électrons est transformée en rayons X. Aussi, compte tenu également des puissances instantanées importantes mises en jeu (de l'ordre de 1 à 100 KW) et des petites dimensions du foyer (de l'ordre du millimètre), les constructeurs ont depuis longtemps réalisé des tubes à rayons X à anodes tournantes où l'anode est mise en rotation pour répartir le flux thermique sur une couronne appelée couronne focale, d'aire plus grande que le foyer, l'intérêt étant d'autant plus grand que la vitesse de rotation est élevée, en général, entre 3.000 et 12.000 tours par minute.

L'anode tournante 12 de type classique a la forme générale d'un disque ayant un axe de symétrie 17 autour duquel elle est mise en rotation à l'aide d'un moteur électrique. Le moteur électrique a un stator 15 situé à l'extérieur de l'enveloppe 13 et un rotor 16 monté dans l'enveloppe et disposé selon l'axe de symétrie 17, le rotor étant mécaniquement solidarisé à l'anode par l'intermédiaire d'un arbre support 18. Ce moteur est généralement de type asynchrone de sorte qu'il ne nécessite pas la création d'un champ inducteur par le rotor. L'énergie dissipée dans un tel tube est élevée et il est donc prévu de le refroidir. Pour cela, le tube est enfermé dans une enceinte ou gaine 19 dans laquelle on fait circuler un liquide de refroidissement 9, notamment de l'huile.

La rotation de l'anode à des vitesses élevées conduit à une usure rapide des paliers du moteur. Aussi, pour allonger leur durée de vie ainsi que pour réduire les pertes Joule du moteur qui sont dissipées dans la gaine renfermant le tube à rayons X, l'anode n'est pas entraînée à grande vitesse en permanence, ce qui signifie qu'il est prévu au moins deux vitesses de rotation, l'une élevée pour l'exposition radiologique proprement dite et l'autre plus faible entre deux expositions, cette dernière pouvant être nulle.

Par ailleurs, il est connu d'utiliser un même tube à rayons X pour créer deux sources de rayons X différentes qui correspondent à des foyers différents par leur taille et à des débits différents. Il en résulte des conditions de fonctionnement différentes et il est habituel d'avoir, pour chaque type de foyer, une vitesse de rotation adaptée. Ainsi, pour un foyer de 0,3 mm, la vitesse de rotation sera de 3.000 tours/minute tandis qu'elle sera de 9.000 tours/minute pour un foyer de 0,1 mm dans lequel l'énergie est concentrée sur une surface plus faible.

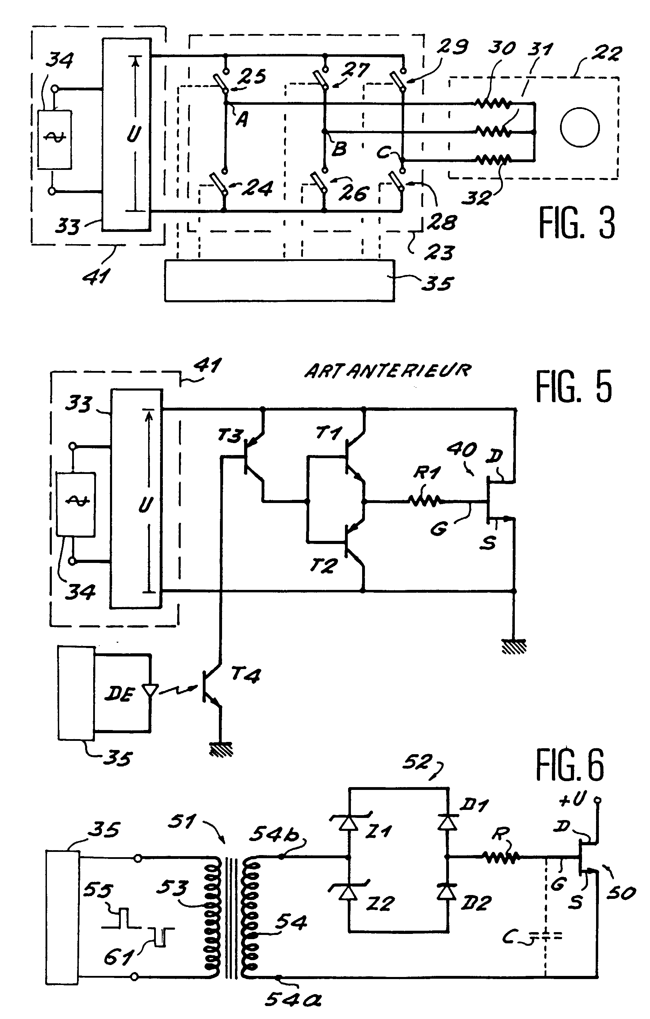

Les diagrammes de la figure 2 montrent, à titre d'exemple, deux cycles de fonctionnement de l'anode tournante d'un tube à rayons X, l'un 20 pour un foyer de 0,3mm et l'autre 21 pour un foyer de 0,1 mm. Les deux cycles sont identiques et comprennent une première phase A qui correspond au démarrage du moteur, une deuxième phase B de maintien de la vitesse (3.000 tours/minute ou 9.000 tours/minute) et une troisième phase C de freinage jusqu'à l'arrêt du moteur. Il existe de nombreuses manières pour obtenir des vitesses variables de rotation de l'anode et l'une d'entre elles est d'utiliser un moteur triphasé dont les enroulements de phase sont alimentés par l'intermédiaire d'un circuit onduleur. Le schéma de principe d'un tel moteur et de l'onduleur d'alimentation est donné par la figure 3. Il comprend un moteur 22 dont le stator permet un bobinage triphasé, ce bobinage étant alimenté par un onduleur triphasé 23 selon le schéma de la figure 3. Sur cette figure, l'onduleur 23 comprend trois paires ou couples d'interrupteurs 24 et 25, 26 et 27, 28 et 29 dont chaque point commun A, B ou C est connecté respectivement à un enroulement 30 pour les interrupteurs 24 et 25, à un enroulement 31 pour les interrupteurs 26 et 27 et à un enroulement 32 pour les interrupteurs 28 et 29. Dans ce schéma, l'onduleur 23 est alimenté par une source 41 de tension continue U réalisée à l'aide d'une source 34 de tension alternative et d'un circuit 33 de redressement et filtrage.

L'ouverture et la fermeture des interrupteurs 24 à 29 sont commandées par un dispositif 35 qui fournit les signaux de commande desdits interrupteurs.

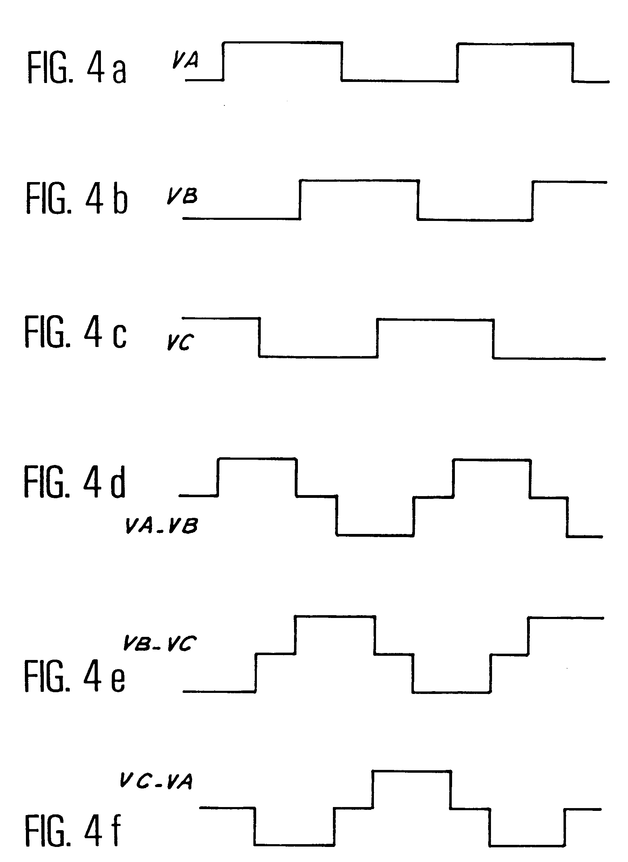

Si l'on considère que les signaux de commandes sont tels que les formes d'ondes VA, VB, VC , mesurées entre les points communs A, B et C des interrupteurs et le pôle négatif de l'alimentation, sont données par les diagrammes des figures 4-a, 4-b et 4-c. Ce sont des signaux carrés déphasés de 120° l'un par rapport à l'autre. Les diagrammes des figures 4-d, 4-e et 4-f donnent le résultat de la combinaison de ces formes d'ondes entre elles telle que la figure 4-d correspond à (VA - VB), la figure 4-e à (VB - VC) et la figure 4-f correspond à (VC - VA). Ces formes d'ondes, appelées couramment ondes pseudosinusoïdales, sont déphasées de 120° l'une par rapport à l'autre.

Le fonctionnement d'un tel dispositif conduit à une élimination naturelle, dans le moteur, des harmoniques de courant de rang multiple de trois qui, comme les harmoniques intermédiaires, ne fournissent pas de couple utile mais créent au contraire des courants parasites et occasionnent des pertes. Enfin, on obtient un allégement du filtre d'entrée car la fréquence de l'ondulation imposée par le moteur triphasé est triplée, ce qui réduit la valeur de la capacité du condensateur de filtrage.

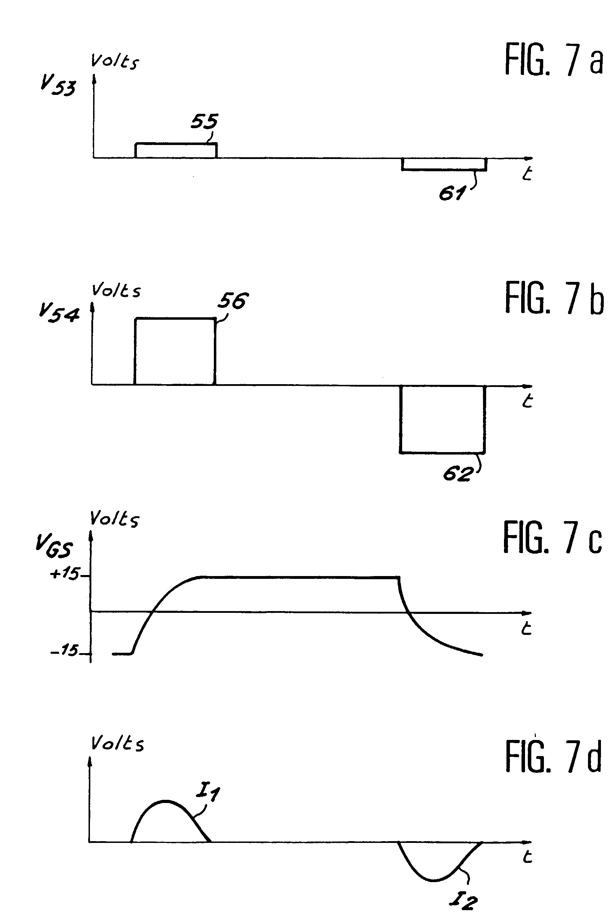

Les interrupteurs qui sont utilisés dans le circuit onduleur sont en général du type électronique tels que les thyratrons, les transistors, les thyristors. Dans les transistors, on utilise de plus ceux du type MOSFET ou IGBT et on aboutit à des circuits de commande du transistor MOSFET ou IGBT semblables à celui de la figure 5.

Un circuit de commande d'un transistor MOSFET 40 comprend une paire de transistors T1 du type NPN et T2 du type PNP montés en série entre les bornes de sortie d'une source 41 de tension continue U représentée, comme sur la figure 3, par une source de tension alternative 34 et un circuit de redressement et filtrage 33. La source 41 alimente également le transistor 40 par application de la tension U entre drain D et la source S. Les émetteurs des transistors T1 et T2 sont reliés entre eux et connectés à la grille de commande G du transistor par l'intermédiaire d'une résistance R1. Les bases des transistors T1 et T2 sont reliées entre elles et connectées au collecteur d'un transistor PNP T3 dont l'émetteur est connecté à la borne positive du circuit d'alimentation. La base du transistor T3 est connectée au collecteur d'un transistor photodétecteur T4 associé à une diode DE émettrice d'un rayonnement, par exemple infrarouge, qui est connectée au circuit de commande 35. Ce circuit de la figure 5 fait apparaître qu'il faut un circuit d'alimentation 41 pour fournir la puissance nécessaire à la commutation du transistor 40 et au circuit d'amplification (transistors T1, T2 et T3) pour amplifier le signal de commande du transistor 40 transmis par une liaison à isolement galvanique du type à photocoupleur comme sur le schéma de la figure 5 ou du type à transformateur d'isolement ou encore du type fibre optique.

Le brevet GB-A-2 109 184 décrit un circuit de commande de commutation d'un transistor à effet de champ qui comprend un dispositif de commande fournissant des impulsions de déclenchement, un transformateur de type impulsionnel auquel sont appliquées les impulsions de déclenchement et un circuit de seuils auquel sont appliquées les impulsions fournies par l'enroulement secondaire du transformateur.

Ce circuit de commande n'est pas satisfaisant en ce qui concerne la démagnétisation des enroulements du transformateur impulsionnel.

Aussi, l'invention concerne un circuit de commande de commutation d'un transistor à effet de champ du type MOS ou d'un transistor bipolaire à grille isolée IGBT comme décrit dans la revendication 1.

D'autres caractéristiques et avantages de la présente invention apparaîtront à la lecture de la description suivante d'un exemple particulier de réalisation, ladite description étant faite en relation avec les dessins joints dans lesquels :
- la figure 1 est un schéma simplifié d'un tube à rayons X,
- la figure 2 est un diagramme montrant deux cycles de fonctionnement d'un moteur d'anode de tube à rayons X,
- la figure 3 est un schéma de principe d'un moteur triphasé alimenté par un onduleur triphasé,
- les figures 4-a à 4-f, sont des diagrammes montrant les formes d'ondes fournies par l'onduleur triphasé de la figure 3,
- la figure 5 est un schéma d'un circuit de commande d'un transistor MOSFET ou IGBT selon l'art antérieur,
- la figure 6 est un schéma d'un circuit de commande d'un transistor MOSFET ou IGBT selon l'invention, .
- les figures 7-a à 7-d sont des diagrammes qui sont utiles pour la compréhension du fonctionnement du circuit de commande selon l'invention;
- les figures 8-a à 8-d sont des diagrammes montrant les signaux à appliquer au transformateur 51 pour le démagnétiser dans le cas d'impulsions successives de même polarité, et
- la figure 9 est un schéma de principe d'un transistor bipolaire à grille isolée IGBT.

Les figures 1 à 5, correspondant à l'art antérieur exposé dans le préambule, ne seront pas décrites à nouveau.

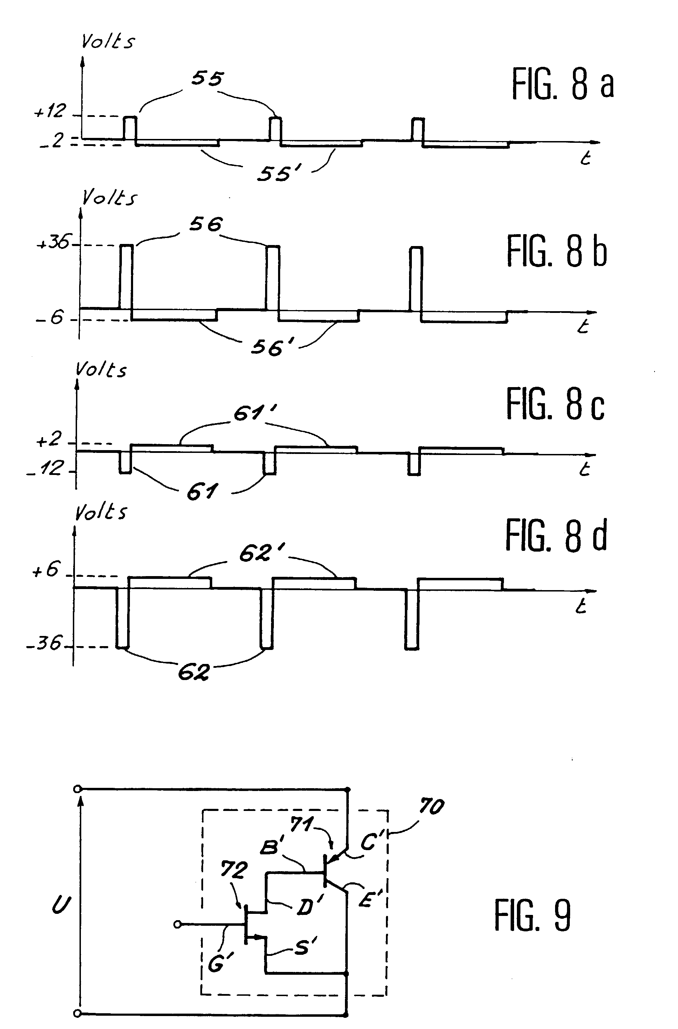

L'invention sera décrite en utilisant un transistor MOSFET 50 mais elle est également applicable à un transistor bipolaire à grille isolée plus connu sous l'abréviation anglo-saxonne IGBT pour "Insulated Gate Bipolar Transistor". La figure 9 donne le schéma de principe d'un tel transistor IGBT 70. Il comprend un transistor PNP 71 dont le collecteur C' et l'émetteur E' sont connectés aux bornes de la source d'alimentation de valeur U et dont la base B' est connectée au drain D' d'un transistor MOSFET 72. La source S' du transistor MOSFET 72 est connectée à l'émetteur E' du transistor 71 et sa grille G' est connectée au circuit de commande selon l'invention comme l'est la grille du transistor MOSFET 50 du circuit de la figure 6. Dans la suite de la description et dans les revendications, on considérera le circuit 70 comme un transistor MOSFET comportant une grille G correspondant à G', un drain D correspondant au collecteur C' et une source S' correspondant à l'émetteur E'.

En relation avec la figure 6, un circuit de commande d'un transistor 50 alimenté par la tension U à commuter et qui peut être du type MOSFET ou IGBT comprend, selon l'invention, un transformateur d'impulsion haute fréquence 51 et un circuit de seuils bipolaire 52 connecté entre le transformateur 51 et le transistor 50. Plus précisément, le transformateur 51 comporte un enroulement primaire 53 et un enroulement secondaire 54. A l'enroulement primaire 53 est appliqué un signal de commande sous la forme d'une impulsion 55 positive ou négative 61 ayant, par exemple, une durée d'environ quatre microsecondes. L'enroulement secondaire 54 a une première borne de sortie 54-b qui est connectée à la grille de commande G du transistor 50 par l'intermédiaire du circuit de seuils bipolaire 52 et une deuxième borne de sortie 54-a qui est connectée directement à la source S du transistor 50. Selon l'invention, le circuit de seuils 52 comprend, en parallèle entre la borne 54-b et la grille de commande G du transistor 50, deux branches qui comportent chacune en série une diode Zener Z1 ou Z2 et une diode D1 ou D2. Dans une branche, les cathodes de la diode Zener Z1 et de la diode D1 sont connectées entre elles, l'anode de la diode Zener Z1 étant connectée à la borne 54-b et l'anode de la diode D1 étant connectée à la grille G; dans l'autre branche, ce sont les anodes de la diode Zener Z2 et de la diode D2 qui sont connectées entre elles, la cathode de la diode Zener Z2 étant connectée à la borne 54-b et la cathode de la diode D2 étant connectée à la grille G. Le point commun des diodes D1 et D2 est connecté à la grille G par une résistance R et un condensateur C connecté entre grille et source représente la capacité parasite qui existe entre la grille G et la source S du transistor MOSFET 50, de l'ordre de 3.10⁻⁹ farad.

Le choix des tensions d'avalanche des diodes Zener Z1 et Z2 est déterminé par la tension V_{GS} entre la grille et la source que l'on souhaite obtenir afin de bloquer le transistor ou de le rendre conducteur. Pour la suite de la description, on supposera que V_{GS} = ± 15 volts. Alors, la tension de Zener sera aussi 15 volts et l'impulsion apparaissant aux bornes 54-a et 54-b de l'enroulement secondaire 54 devra être de 30 volts.

Ce choix des tensions de Zener et d'impulsion sera mieux compris à l'aide de la description suivante du fonctionnement du circuit de la figure 6 en s'aidant des diagrammes des figures 7 et 8.

Lorsqu'une impulsion positive 55 (figures 6 et 7-a, tension V₅₃) est appliquée à l'enroulement primaire 53, le rapport de transformation est tel que l'impulsion 56 (tension V₅₄-figure 7-b) qui apparaît aux bornes 54-a et 54-b est également positive mais d'une valeur de 30 volts. Si l'on suppose que le transistor 50 est bloqué par une tension V_{GS} =- 15 volts qui est fournie par la charge du condensateur C, l'application de l'impulsion 56 provoque la conduction de la diode Z2 en sens inverse et la conduction de la diode D2 en sens direct et un courant I₁ (figure 7-d), dit positif, décharge le condensateur C, chargé négativement, puis le charge à une tension V_{GS} voisine de 15 volts (figure 7-c). Dès que la tension de charge V_{GS} dépasse 4 volts, le transistor 50 conduit. Le courant de charge du condensateur est limité par la self de fuite du transformateur 51, la résistance R assurant l'amortissement du circuit résonnant constitué par cette self de fuite et les capacités parasites C. A la fin de l'impulsion, le condensateur est chargé à la tension + 15 volts (figure 7-c).

Lorsque le flanc arrière de l'impulsion 56 revient au potentiel de la masse, la tension de seuil des diodes Zener maintient la tension V_{GS} à + 15 volts.

Pour bloquer le transistor 50, une impulsion négative 61 est appliquée à l'enroulement primaire 53 et il en résulte une impulsion négative 62 de - 30 volts aux bornes de l'enroulement secondaire 54. Cette impulsion 62 provoque la conduction en sens inverse de la diode Zener Z1 et la conduction en sens direct de la diode D1. Le condensateur C se décharge (courant I₂-figure 7-d) et lorsque sa tension arrive à 2 volts, le transistor 50 se bloque. Le condensateur C se charge ensuite à la tension négative - 15 volts (figure 7-c) grâce au courant I₂.

Lorsque le flanc arrière de l'impulsion 62 revient au potentiel de la masse, la tension du seuil des diodes Zener maintient la tension V_{GS} à - 15 volts.

Le cycle qui vient d'être décrit se répète lors de l'apparition d'une impulsion positive, puis d'une impulsion négative et ainsi de suite.

Avec un tel circuit, il est possible de maintenir l'état conducteur ou bloqué du transistor 50 en maintenant la tension de charge du condensateur C par l'application d'impulsions 55 positives successives (tension V_{GS} positive) ou d'impulsions 61 négatives successives (tension V_{GS} négative) à l'enroulement primaire 53 du transformateur 51.

Ainsi, le circuit 35 fournira des impulsions 55 ou 61 de même signe à intervalles réguliers de période égale à dix millisecondes par exemple.

Lorsque des impulsions successives de même signe sont appliquées à l'enroulement primaire 53 du transformateur 51, il est prévu de démagnétiser le transformateur entre deux impulsions de même signe en faisant suivre l'impulsion positive 55 (ou négative 61) par une impulsion négative 55'-figure 8-a (ou positive 61'-figure 8-c). La durée et l'amplitude des impulsions 55 et 55' (ou 61 et 61') doivent être telles que leurs produits soient égaux.

Par ailleurs, pour que cette impulsion 55' ou 61' ne décharge pas le condensateur C, ou prend une marge en tension en employant, par exemple, des zeners Z1 et Z2 présentant des tensions d'avalanche de 21 volts au lieu de 15 volts. Ceci conduit à des impulsions 56 et 62 au secondaire du transformateur 51 qui ont une amplitude de 36 volts au lieu de 30 volts de manière à charger le condensateur C à ± 15 volts.

Alors, si les impulsions 56 et 62 ont une amplitude de 36 volts et une durée de quatre microsecondes, les impulsions 56' et 62' (figures 8-b et 8-d) de démagnétisation auront une durée de 24 microsecondes si leur amplitude au secondaire est de 6 volts.

Sur la figure 8, on a représenté les impulsions 55 et 61 comme apparaissant aux mêmes instants; bien entendu, dans la réalité, elles apparaissent à des instants différents.

## Revendications

1. Un circuit de commande de commutation d'un transistor (50) à effet de champ du type MOS ou d'un transistor bipolaire à grille isolée IGBT (70), comprenant :
- un dispositif de commande (35) fournissant des impulsions de tension de déclenchement (55, 61).
- un transformateur (51) du type impulsionnel ayant un enroulement primaire (53) qui est connecté audit dispositif de commande pour recevoir lesdites impulsions de déclenchement (55, 61), et un enroulement secondaire (54) dont les première et deuxième bornes de sortie (54-b, 54-a) sont connectées respectivement à la grille (G) et à la source (S) dudit transistor (50, 70),
- un circuit de seuils bipolaire (52) connecté entre la première borne de sortie (54-b) dudit enroulement secondaire (54) et la grille (G) dudit transistor (50, 70),
- le circuit de seuils bipolaire comprenant deux branches en parallèle, une première branche comportant une première diode Zener (Z1) dont la cathode est connectée à la cathode d'une première diode (D1) et une deuxième branche comportant une deuxième diode Zener (Z2) dont l'anode est connectée à l'anode d'une deuxième diode (D2), le point commun de l'anode de la première diode (Z1) et de la cathode de la deuxième diode Zener (Z2) étant connecté à la première borne de sortie du transformateur tandis que le point commun de l'anode de la première diode (D1) et de la cathode de la deuxième diode (D2) est connecté à la grille dudit transistor (50).
- les impulsions de déclenchement (55, 61) fournies par ledit dispositif de commande (35) étant de polarités positive ou négative et,
- chaque impulsion de déclenchement positive (55) ou négative (61) étant suivie respectivement d'une impulsion négative (55') ou positive (61') d'amplitude plus faible que la première impulsion (55, 61) mais de durée plus longue de manière à démagnétiser les enroulements dudit transformateur (51) avant le début de l'impulsion suivante de même polarité de sorte qu'une impulsion de déclenchement positive rend et maintient conducteur ledit transistor (50, 70) par suite de la charge positive des capacités parasites (C) entre la grille (G) et la source (S) dudit transistor tandis qu'une impulsion négative bloque ledit transistor (50, 70) et le maintient bloqué par suite de la charge négative desdites capacités parasites (C).

2. Circuit selon la revendication 1, caractérisé en ce que le circuit de seuils bipolaire (52) est connecté à la grille (G) dudit transistor (50, 70) par l'intermédiaire d'une résistance (R).

## Patentansprüche

1. Schaltsteuerschaltung eines MOS-Feldeffekttransistors (50) oder eines bipolaren Transistors mit isoliertem Gate IGBT (70), die aufweist:
- eine Steuervorrichtung (35), die Auslöse-Spannungsimpulse (55, 61) liefert,
- einen Impulstransformator (51) mit einer Primärwicklung (53), die mit der Steuervorrichtung verbunden ist, um die Auslöseimpulse (55, 61) zu empfangen, und mit einer Sekundärwicklung (54), deren erste und zweite Ausgangsklemme (54-b, 54-a) mit dem Gate (G) bzw. mit der Source (S) des Transistors (50, 70) verbunden sind,
- eine bipolare Schwellenschaltung (52), die zwischen die erste Ausgangsklemme (54-b) der Sekundärwicklung (54) und das Gate des Transistors (50, 70) geschaltet ist, wobei die bipolare Schwellenschaltung zwei parallelgeschaltete Zweige aufweist, einen ersten Zweig, der eine erste Zener-Diode (Z1) enthält, deren Kathode mit der Kathode einer ersten Diode (D1) verbunden ist, und einen zweiten Zweig, der eine zweite Zener-Diode (Z2) enthält, deren Anode mit der Anode einer zweiten Diode (D2) verbunden ist, wobei der gemeinsame Punkt der Anode der ersten Diode (Z1) und der Kathode der zweiten Zener-Diode (Z2) mit der ersten Ausgangsklemme des Transformators verbunden ist, während der gemeinsame Punkt der Anode der ersten Diode (D1) und der Kathode der zweiten Diode (D2) mit dem Gate des Transistors (50) verbunden ist,
- wobei die von der Steuervorrichtung (35) gelieferten Auslöseimpulse (55, 61) positiv oder negativ polarisiert sind,
- wobei jeder positive (55) oder negative Auslöseimpuls (61) von einem negativen (55') bzw. positiven Impuls (61') gefolgt wird, dessen Amplitude geringer als die des ersten Impulses (55, 61), aber von längerer Dauer ist, so daß die Wicklungen des Transformators (51) vor dem Beginn des folgenden Impulses gleicher Polarität entmagnetisiert werden, so daß ein positiver Auslöseimpuls den Transistor (50, 70) leitend macht und leitend hält aufgrund der positiven Ladung der Störkapazitäten (C) zwischen dem Gate (G) und der Source (S) des Transistors, während ein negativer Impuls den Transistor (50, 70) blockiert und ihn aufgrund der negativen Ladung der Störkapazitäten (C) blockiert hält.

2. Schaltung nach Anspruch 1, dadurch gekennzeichnet, daß die bipolare Schwellenschaltung (52) mit dem Gate (G) des Transistors (50, 70) über einen Widerstand (R) verbunden ist.

## Claims

1. A switching control circuit for a field effect transistor (50) of the MOS type or an isolated gate bipolar transistor (70) comprising:
- a control device (35) supplying trigger voltage pulses (55, 61),
- a transformer (51) of the pulse type having a primary winding (53) connected to said control device in order to receive said trigger pulses (55, 61) and a secondary winding (54), the first and second output terminals (54-b, 54-a) of which are connected to the gate (G) and the source (S) of said transistor (50, 70) respectively,
- a bipolar threshold circuit (52) connected between the first output terminal (54-b) of said secondary winding (54) and the gate (G) of said transistor (50, 70),
- the bipolar threshold circuit comprising two branches in parallel, a first branch having a first Zener diode (Z1) whose cathode is connected to the cathode of a first diode (D1) and a second branch having a second Zener diode (72) whose anode is connected to the anode of a second diode (D2), the common point of the anode of the first Zener diode (Z1) and the cathode of the second Zener diode (Z2) being connected to the first output terminal of the transformer whilst the common point of the anode of the first diode (D1) and the cathode of the second diode (D2) is connected to the gate of said transistor (50),
- the trigger pulses (55, 61) supplied by said control device (35) being of positive or negative polarity and
- each positive (55) or negative (61) trigger pulse being followed respectively by a negative (55') or positive (61') pulse of a lesser amplitude than the first pulse (55, 61) but of a longer duration, such that the windings of said transformer (51) are demagnetised before the start of the subsequent pulse of same polarity so that a positive trigger pulse renders and keeps said transistor (50, 70) conductive following the positive charge of the parasitic capacitances (C) between the gate (G) and the source (S) of said transistor whilst a negative pulse blocks said transistor (50, 70) and keeps it blocked following the negative charge of said parasitic capacitances (C).

2. A circuit as claimed in claim 1, characterised in that the bipolar threshold circuit (52) is connected to the gate (G) of said transistor (50, 70) by means of a resistor (R).
